# EUROPEAN PATENT SPECIFICATION

(11) **EP 4 295 397 B1**
(45) Date of publication and mention of the grant of the patent: **07.10.2026**
(21) Application number: 21930847.5
(22) Date of filing: 18.03.2021
(51) Int. Cl.: H10W 70/60, H10W 70/65, H10W 72/00, H10W 72/50, H10W 72/59, H10W 72/60, H10W 72/90, H10W 90/00

(54) **HIGH-SYMMETRICAL SEMICONDUCTOR ARRANGEMENT**
HOCHSYMMETRISCHE HALBLEITERANORDNUNG
AGENCEMENT DE SEMI-CONDUCTEURS HAUTEMENT SYMÉTRIQUES

(43) Date of publication of application: 27.12.2023
(73) Proprietor: Huawei Technologies Co., Ltd., Shenzhen, Guangdong 518129 (CN)
(72) Inventor: HOEGERL, Juergen, 82362 Weilheim (DE); DU, Ruoyang, Shenzhen, Guangdong 518129 (CN); CHEN, Huibin, Shenzhen, Guangdong 518129 (CN)
(74) Representative: Goddar, Heinz J.
(86) International application number: PCT/CN2021/081627
(87) International publication number: WO 2022/193255

(56) References cited:
- CN-A- 101 263 547
- CN-A- 103 855 914
- CN-A- 105 355 611
- CN-A- 110 120 751
- CN-A- 111 106 098
- US-A1- 2011 310 645
- US-A1- 2020 343 226
- US-B1- 9 214 416

## Description

### TECHNICAL FIELD

The present disclosure relates to the field of semiconductor arrangements like power semiconductor modules that may be used in automotive, industrial and consumer electronic applications for driving loads, converting power, or the like. In particular the present disclosure relates to high symmetrical substrate layout for semiconductor arrangement, in particular Silicon Carbide (SiC) based molded module.

### BACKGROUND

In a semiconductor arrangement with multiple semiconductor elements, the switching state of a controllable semiconductor element, e.g. whether the load path is electrically conducting or blocking, depends on its individual control voltage, i.e. on the difference between the electric potential of the control electrode and, e.g., the first load electrode of the corresponding controllable semiconductor element. A large current flowing through a line electrically connecting the first load electrodes can, in combination with the inevitable ohmic resistance and/or inductance of that line, lead to significantly different electric potentials at the first load electrodes of the different controllable semiconductor elements. Therefore, in some situations the switching states of different controllable semiconductor elements significantly differ from each other. That is, there are instants of time at which the load paths of some of the controllable semiconductor elements are electrically conducting, whereas the control paths of the remaining controllable semiconductor elements are electrically blocking. As a result, the electric load current through the controllable semiconductor elements having their load paths connected in parallel and, therefore, the thermal and electrical load caused by the electric load current are unevenly distributed among the controllable semiconductor elements. Hereby, the lifetime of the more heavily burdened controllable semiconductor elements may be reduced. Further, different switching states may arise from undesired interbody oscillations between the controllable semiconductor elements. CN111106098 A discloses a power module with a low-inductance circuit layout.

The described problems are, without being restricted to, of particular interest with regard to fast switching semiconductor elements like semiconductor elements based on silicon carbide (e.g. SiC-based MOSFETs or SiC-based IGBTs) because the silicon-carbide-based semiconductor chips presently available have small foot-print areas and, therefore, low rated currents so that there is a frequent requirement of electrically connecting silicon carbide based semiconductor chips in parallel.

### SUMMARY

It is an object of this disclosure to provide a solution for a semiconductor arrangement without the above described disadvantages.

It is particularly an object of this disclosure to provide a semiconductor arrangement or a semiconductor assembly that reduces or prevents at least one of the above-described drawbacks that can occur when the load paths of two or more controllable semiconductor elements are operated in parallel.

This object is achieved by the features of the independent claim. Further implementation forms are apparent from the dependent claims, the description and the figures.

A basic idea of this disclosure is to introduce symmetry into current flow on substrate and lead frame level.

This symmetric substrate concept can be advantageously applied to semiconductor arrangements of different size, for example such as 6 chips in parallel per switch.

The basic concept is a high symmetrical substrate layout, e.g. for molded single side cooled module enabling reliable switching of semiconductor chips like SiC chips, for example within module.

In an example implementation of this substrate layout a third/middle row of chips may be introduced for high and low side. On the high side the third/middle row may be accessed by 3-dimensional interconnect element (e.g. clip) to improve symmetry.

In order to describe the invention in detail, the following terms, abbreviations and notations will be used:
- SiC: silicon carbide
- MOSFET: metal oxide semiconductor field effect transistor
- IGBT: insulated gate bipolar transistor

According to a first aspect, the disclosure relates to a semiconductor arrangement, comprising: a substrate having a top side and a bottom side opposite to the top side; a first group of semiconductor elements forming a first switch, each semiconductor element of the first group comprising a load path formed between a first load electrode arranged on a first main surface of the respective semiconductor element and a second load electrode arranged on a second main surface opposite to the first main surface of the respective semiconductor element, wherein the first load electrode of each semiconductor element of the first group is placed on the top side of the substrate; a second group of semiconductor elements forming a second switch, each semiconductor element of the second group comprising a load path formed between a first load electrode arranged on a first main surface of the respective semiconductor element and a second load electrode arranged on a second main surface opposite to the first main surface of the respective semiconductor element, wherein the first load electrode of each semiconductor element of the second group is placed on the top side of the substrate; wherein the substrate comprises: a first electrically conductive area on the top side of the substrate, accommodating at least a first semiconductor element of the first group of semiconductor elements; a second electrically conductive area on the top side of the substrate, separated from the first electrically conductive area, the second electrically conductive area accommodating at least a second semiconductor element of the first group of semiconductor elements; a third electrically conductive area on the top side of the substrate, separated from the first electrically conductive area and the second electrically conductive area, the third electrically conductive area accommodating at least a third semiconductor element of the first group of semiconductor elements; a fourth electrically conductive area insulated from the first electrically conductive area, the second electrically conductive area and the third electrically conductive area, the fourth electrically conductive area accommodating at least a first semiconductor element, a second semiconductor element and a third semiconductor element of the second group of semiconductor elements; the semiconductor arrangement further comprising: a first electrical connection line configured to electrically connect the second load electrodes of the semiconductor elements of the first group with each other and with the fourth electrically conductive area of the substrate; a second electrical connection line configured to electrically connect the second load electrodes of the semiconductor elements of the second group with each other; and a third electrical connection line configured to electrically connect the first electrically conductive area, the second electrically conductive area and the third electrically conductive area of the substrate; wherein the first electrical connection line, the second electrical connection line, the third electrical connection line and the fourth electrically conductive area of the substrate are dimensioned according to a symmetry criterion to enable a simultaneous current flow through the load paths of the semiconductor elements of the first group as well as a simultaneous current flow through the load paths of the semiconductor elements of the second group.

Such a semiconductor arrangement can reduce or even prevent the above-described drawbacks that can occur when the load paths of two or more controllable semiconductor elements are operated in parallel.

The high symmetrical substrate layout enables reliable switching of the semiconductor elements. Such a reliable switching is particularly advantageous for SiC chips within the semiconductor arrangement and more particularly for a molded single side cooled module.

In an exemplary implementation of the semiconductor arrangement, the fourth electrically conductive area of the substrate is dimensioned to separate the first electrically conductive area, the second electrically conductive area and the third electrically conductive area of the substrate from each other.

This provides the advantage that the fourth area can be designed to isolate the first group of semiconductor elements from the second group of semiconductor elements, e.g. the high side switch from the low side switch.

In an exemplary implementation of the semiconductor arrangement, the fourth area of the substrate comprises a comb-shaped structure, wherein first teeth of the comb-shaped structure are dimensioned to separate the first area, the second area and the third area of the substrate from each other.

This provides the advantage that by such comb-shaped structure substrate area can be efficiently utilized to accommodate both groups of semiconductor elements.

In an exemplary implementation of the semiconductor arrangement, second teeth of the comb-shaped structure are dimensioned to accommodate the first semiconductor element, the second semiconductor element and the third semiconductor element of the second group of semiconductor elements.

This provides the advantage that substrate space can be efficiently used to accommodate the second group of semiconductor elements by forming such second teeth.

In an exemplary implementation of the semiconductor arrangement, the second teeth of the comb-shaped structure are formed opposite to the first teeth of the comb-shaped structure.

This provides the advantage of efficient utilization of substrate space.

In an exemplary implementation of the semiconductor arrangement, the second teeth of the comb-shaped structure are sequentially and equidistantly arranged on the top side of the substrate.

Besides efficient utilization of substrate space this provides the advantage of bridging between the teeth structures to exploit symmetry for the semiconductor elements.

In an exemplary implementation of the semiconductor arrangement, the first electrically conductive area, the second electrically conductive area and the third electrically conductive area are sequentially arranged on the top side of the substrate.

This provides the advantage of exploiting symmetry effects for simultaneously switching of the semiconductor elements.

In an exemplary implementation of the semiconductor arrangement, a distance between the first electrically conductive area to the second electrically conductive area on the top side of the substrate corresponds to a distance between the second electrically conductive area and the third electrically conductive area on the top side of the substrate.

This provides the advantage of providing a high symmetrical design for simultaneously switching of the semiconductor elements.

In an exemplary implementation of the semiconductor arrangement, the first electrical connection line comprises a first part configured to electrically connect the second load electrodes of the first semiconductor element, the second semiconductor element and the third semiconductor element of the first group of semiconductor elements with each other. This provides the advantage that the first electrical connection line allows to simultaneously (or nearly simultaneously) establish a current path via the second load electrodes.

In an exemplary implementation of the semiconductor arrangement, the first part of the first electrical connection line is dimensioned to form a straight connection line with respect to the top side of the substrate.

This provides the advantage that this straight connection line allows to simultaneously establish the current path via the second load electrodes.

In an exemplary implementation of the semiconductor arrangement, the first electrical connection line comprises a second part configured to electrically connect the second load electrodes of another semiconductor element of the first group arranged on the first electrically conductive area, another semiconductor element of the second group arranged on the second electrically conductive area and another semiconductor element of the third group arranged on the third electrically conductive area.

This provides the advantage that the first electrical connection line allows to simultaneously (or nearly simultaneously) establish a current path via the second load electrodes of the other semiconductor elements of the first group of semiconductor elements.

In an exemplary implementation of the semiconductor arrangement, the second part of the first electrical connection line is dimensioned to form a straight connection line with respect to the top side of the substrate.

This provides the advantage that this straight connection line allows to simultaneously establish the current path via the second load electrodes of the other semiconductor elements of the first group of semiconductor elements.

In an exemplary implementation of the semiconductor arrangement, the third electrical connection line is dimensioned to form a straight connection line with respect to the top side of the substrate.

This provides the advantage that this straight connection line allows to simultaneously establish the current path.

In an exemplary implementation of the semiconductor arrangement, the semiconductor arrangement comprises: a fifth electrically conductive area insulated from the first area, the second area, the third area and the fourth area, wherein the second electrical connection line is configured to electrically connect the second load electrodes of the semiconductor elements of the second group with the fifth area.

This provides the advantage that this fifth conductive area allows to simultaneously establish the current path via the second group of semiconductor elements, e.g. for the low side switch.

In an exemplary implementation of the semiconductor arrangement, the semiconductor arrangement comprises: a first lead frame configured to electrically connect the third area to a first external terminal, wherein the first lead frame is welded on the third area of the substrate; a second lead frame configured to electrically connect the fifth area to a second external terminal, wherein the second lead frame is welded on the fifth area of the substrate; and a third lead frame configured to electrically connect the fourth area to a second external terminal, wherein the third lead frame is welded on the fourth area of the substrate.

This provides the advantage that the first lead frame provides a high conductivity in order to carry high currents from the switch to the external terminal.

In an exemplary implementation of the semiconductor arrangement, the semiconductor arrangement comprises: a fourth lead frame configured to electrically connect the first area; and an electrically conductive bridge configured to electrically connect the fourth lead frame with the first lead frame by bridging the second lead frame.

This provides the advantage that the fourth lead frame provides a high conductivity in order to carry high currents from the switch to the external terminal. The bridge provides the advantage of flexible design options due to connections of two lead frames via a third dimension. The bridge advantageously allows to use two lead frames at the same electrical potential in order to exploit symmetry.

In an exemplary implementation of the semiconductor arrangement, the semiconductor arrangement comprises: a mold compound embedding the first group of semiconductor elements, the second group of semiconductor elements, the first electrical connection line, the second electrical connection line and the third electrical connection line.

This provides the advantage that the mold compound protects the semiconductor arrangement from the outside.

In an exemplary implementation of the semiconductor arrangement, the semiconductor elements of the first group of semiconductor elements and the semiconductor element of the second group of semiconductor elements are Silicon Carbide semiconductors.

This provides the advantage that this design is well suited particularly for fast switching SiC semiconductors.

In an exemplary implementation of the semiconductor arrangement, the semiconductor arrangement is forming a single side cooled molded power module for automotive applications.

This provides the advantage that this semiconductor arrangement can be advantageously applied in automotive applications with high power semiconductors.

### BRIEF DESCRIPTION OF THE DRAWINGS

Further embodiments of the invention will be described with respect to the following figures, in which:
Fig. 1 shows a circuit diagram illustrating an exemplary semiconductor arrangement 100 according to the disclosure;
Fig. 2 shows a schematic diagram illustrating an exemplary H-bridge circuit 200 using semiconductor arrangements according to the disclosure;
Fig. 3 shows a circuit diagram illustrating an exemplary semiconductor arrangement 300 according to the disclosure;
Fig. 4 shows a circuit diagram illustrating an exemplary semiconductor arrangement 400 according to the disclosure; and
Fig. 5 shows a schematic diagram illustrating a method 500 for producing a semiconductor arrangement according to the disclosure.

### DETAILED DESCRIPTION OF EMBODIMENTS

In the following detailed description, reference is made to the accompanying drawings, which form a part thereof, and in which is shown by way of illustration specific aspects in which the disclosure may be practiced. It is understood that other aspects may be utilized and structural or logical changes may be made without departing from the scope of the present disclosure. The following detailed description, therefore, is not to be taken in a limiting sense, and the scope of the present disclosure is defined by the appended claims.

It is understood that comments made in connection with a described method may also hold true for a corresponding device or system configured to perform the method and vice versa. For example, if a specific method step is described, a corresponding device may include a unit to perform the described method step, even if such unit is not explicitly described or illustrated in the figures. Further, it is understood that the features of the various exemplary aspects described herein may be combined with each other, unless specifically noted otherwise.

The semiconductor arrangements, devices and systems described herein may, for example, be implemented in automotive, industrial or consumer electronic applications, e.g. for driving loads, converting power, etc. The semiconductor arrangements, devices and systems described herein may also be implemented in wireless communication schemes, e.g. communication schemes according to 5G or WiFi, e.g. for Internet of Things, etc. The described semiconductor arrangements, devices and systems may be used to produce integrated circuits and/or power semiconductors and may be manufactured according to various technologies. For example, the semiconductor arrangements, devices and systems may be utilized in logic integrated circuits, analog integrated circuits, mixed signal integrated circuits, optical circuits, memory circuits and/or integrated passives.

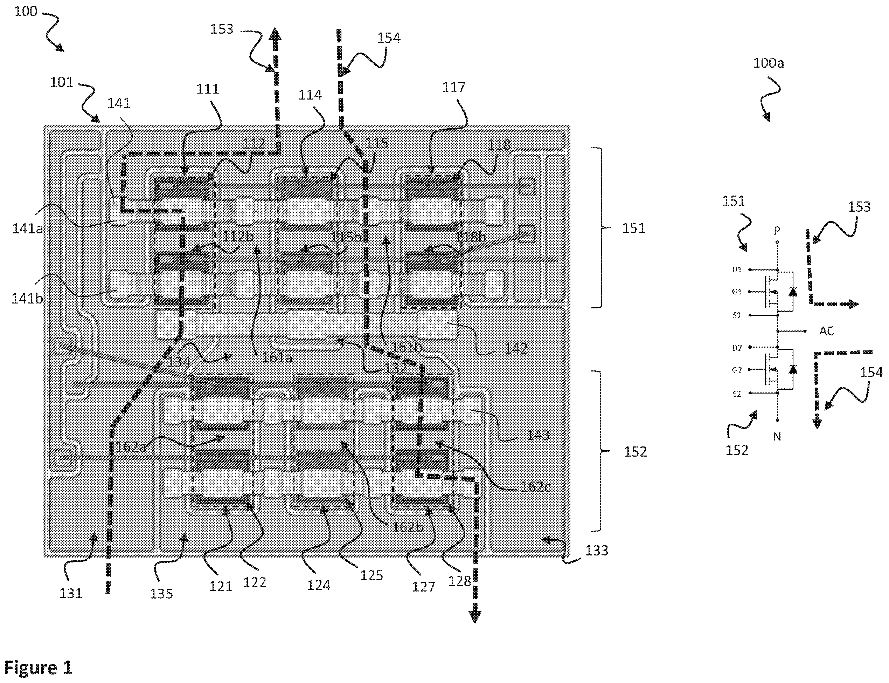

Fig. 1 shows a circuit diagram illustrating an exemplary semiconductor arrangement 100 according to the disclosure.

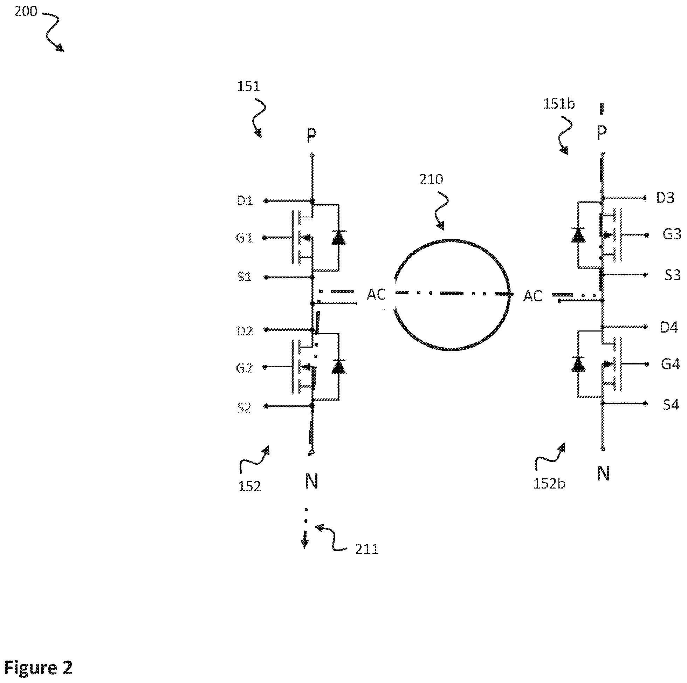

The semiconductor arrangement 100 forms a switching circuit 100a comprising a first switch 151 and a second switch 152 connected in series as illustrated on the right side of Figure 1. The first switch 151 is connected between a first terminal P and a third terminal AC. The second switch 152 is connected between a second terminal N and the third terminal AC. For example, the switching circuit 100a may switch a DC voltage between first and second terminals P and N to an AC voltage at the third terminal AC. A first current path 153 through first switch 151 is established from first terminal P to third terminal AC. A second current path 154 through second switch 152 is established from third terminal AC to second terminal N. Both, first and second current paths 153, 154 are illustrated in the semiconductor arrangement 100. The first switch 151 may implement a high-side switch, for example. The second switch 152 may implement a low-side switch, for example. Both switches 151, 152 may implement a half bridge or part of a full H-bridge as exemplarily shown in Figure 2.

The first switch 151 may be implemented by a field effect transistor (FET) having a drain terminal D1, a source terminal S1 and a gate terminal G1 and a diode connected in parallel to the FET. Alternatively, an insulated gate bipolar transistor (IGBT) may be used instead of the FET. The source terminal S1 may form a first load electrode as described in the following. The drain terminal D1 may form a second load electrode as described in the following. The gate terminal G1 may form a control electrode.

The semiconductor arrangement 100 comprises: a substrate 101, a first group of semiconductor elements 111, 114, 117 and a second group of semiconductor elements 121, 124, 127.

The first group of semiconductor elements 111, 114, 117 may comprise multiple semiconductor elements, for example a number of six semiconductor elements as shown in Figure 1. It is to be understood that the first group may also have any other number of semiconductor elements, for example nine, twelve, fifteen or even only three elements.

The second group of semiconductor elements 121, 124, 127 may comprise multiple semiconductor elements, for example a number of six semiconductor elements as shown in Figure 1. It is to be understood that the second group may also have any other number of semiconductor elements, for example nine, twelve, fifteen or even only three elements. In one example, the number of semiconductor elements of the first group may correspond to the number of semiconductor elements of the second group but this is not a restriction. For example, the first group may have three semiconductor elements and the second group may have six semiconductor elements or any other configuration is possible as well.

The substrate 101 has a top side and a bottom side opposite to the top side.

The first group of semiconductor elements 111, 114, 117 are forming a first switch 151, each semiconductor element of the first group comprising a load path formed between a first load electrode arranged on a first main surface of the semiconductor element and a second load electrode arranged on a second main surface opposite to the first main surface of the semiconductor element, wherein the first load electrode of each semiconductor element of the first group is placed on the top side of the substrate.

The second group of semiconductor elements 121, 124, 127 are forming a second switch, each semiconductor element of the second group comprising a load path formed between a first load electrode arranged on a first main surface of the semiconductor element and a second load electrode arranged on a second main surface opposite to the first main surface of the semiconductor element, wherein the first load electrode of each semiconductor element of the second group is placed on the top side of the substrate 101.

The substrate 101 comprises a first electrically conductive area 131 on the top side of the substrate, accommodating at least a first semiconductor element 112 of the first group of semiconductor elements 111, 114, 117.

The substrate 101 comprises a second electrically conductive area 132 on the top side of the substrate, insulated from the first area, the second area accommodating at least a second semiconductor element 115 of the first group of semiconductor elements 111, 114, 117.

The substrate 101 comprises a third electrically conductive area 133 on the top side of the substrate, insulated from the first area and the second area, the third area accommodating at least a third semiconductor element 118 of the first group of semiconductor elements 111, 114, 117.

The substrate 101 comprises a fourth electrically conductive area 134 insulated from the first area, the second area and the third area. The fourth area 134 accommodates at least a first semiconductor element 122, a second semiconductor element 125 and a third semiconductor element 128 of the second group of semiconductor elements 121, 124, 127.

The semiconductor arrangement 100 further comprises a first electrical connection line 141 configured to electrically connect the second load electrodes of the semiconductor elements of the first group 111, 114, 117 with each other and with the fourth area 134 of the substrate.

The semiconductor arrangement 100 comprises a second electrical connection line 143 configured to electrically connect the second load electrodes of the semiconductor elements of the second group 121, 124, 127 with each other.

The semiconductor arrangement 100 comprises a third electrical connection line 142 configured to electrically connect the first area 131, the second area 132 and the third area 133 of the substrate.

The first electrical connection line 141, the second electrical connection line 143, the third electrical connection line 142 and the fourth area 134 of the substrate 101 are dimensioned according to a symmetry criterion to enable a simultaneous current flow through the load paths of the semiconductor elements of the first group 111, 114, 117 as well as a simultaneous current flow through the load paths of the semiconductor elements of the second group 121, 124, 127.

The fourth area 134 of the substrate may be dimensioned to separate the first area 131, the second area 132 and the third area 133 of the substrate from each other.

The fourth area 134 of the substrate may comprise a comb-shaped structure having first teeth 161a, 161b and second teeth 162a, 162b, 162c. The first teeth 161a, 161b of the comb-shaped structure may be dimensioned to separate the first area 131, the second area 132 and the third area 133 of the substrate from each other. The second teeth 162a, 162b, 162c of the comb-shaped structure may be dimensioned to accommodate the semiconductor element 122, the second semiconductor element 125 and the third semiconductor element 128 of the second group of semiconductor elements 121, 124, 127.

The second teeth 162a, 162b, 162c of the comb-shaped structure may be formed opposite to the first teeth 161a, 161b of the comb-shaped structure.

The second teeth 162a, 162b, 162c of the comb-shaped structure may be sequentially and equidistantly arranged on the top side of the substrate 101.

The first electrically conductive area 131, the second electrically conductive area 132 and the third electrically conductive area 133 may be sequentially arranged on the top side of the substrate 101.

A distance between the first electrically conductive area 131 to the second electrically conductive area 132 on the top side of the substrate 101 may correspond to a distance between the second electrically conductive area 132 and the third electrically conductive area 133 on the top side of the substrate.

The first electrical connection line 141 may comprises a first part 141a configured to electrically connect the second load electrodes of the first semiconductor element 112, the second semiconductor element 115 and the third semiconductor element 118 of the first group of semiconductor elements 111, 114, 117 with each other. The first part 141a of the first electrical connection line 141 may be dimensioned to form a straight connection line with respect to the top side of the substrate 101.

The first electrical connection line 141 may comprise a second part 141b configured to electrically connect the second load electrodes of another first semiconductor element 112b arranged on the first electrically conductive area 131, another second semiconductor element 115b arranged on the second electrically conductive area 132 and another third semiconductor element 118b arranged on the third electrically conductive area 131.

The second part 141b of the first electrical connection line 141 may be dimensioned to form a straight connection line with respect to the top side of the substrate 101.

The third electrical connection line 142 may be dimensioned to form a straight connection line with respect to the top side of the substrate 101.

The semiconductor arrangement 100 may comprise a fifth electrically conductive area 135 insulated from the first area 131, the second area 132, the third area 133 and the fourth area 134. The second electrical connection line 143 may be configured to electrically connect the second load electrodes of the semiconductor elements of the second group 121, 124, 127 with the fifth area 135.

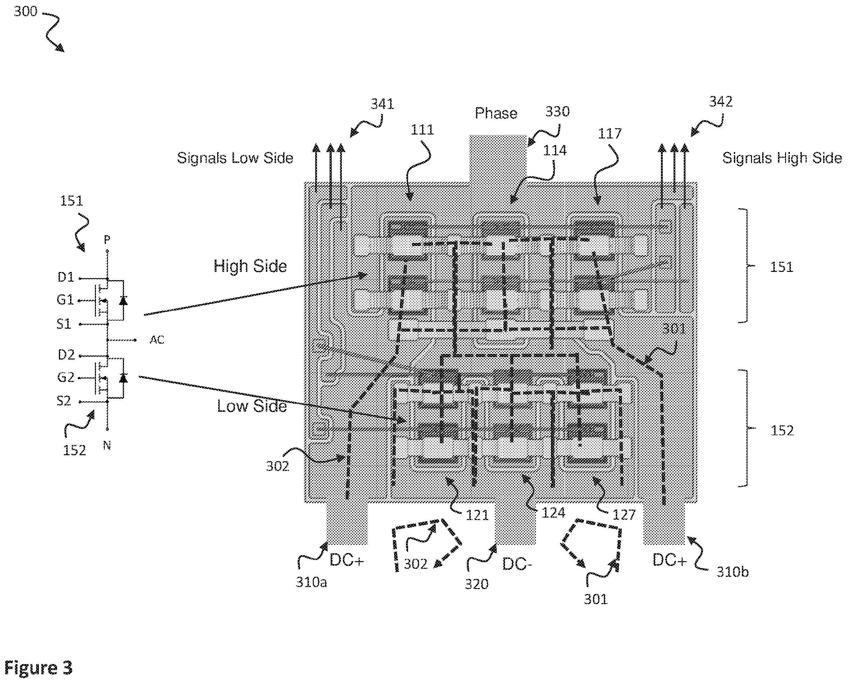

The semiconductor arrangement 100 may comprise a first lead frame 310b configured to electrically connect the third area 133 to a first external terminal, e.g. terminal DC+ as shown in Figure 3. The first lead frame 310b may be welded on the third area 133 of the substrate 101, for example.

The semiconductor arrangement 100 may comprise a second lead frame 320 as shown in Figure 3 configured to electrically connect the fifth area 135 to a second external terminal, e.g. terminal DC- as shown in Figure 3. The second lead 320 frame may be welded on the fifth area 135 of the substrate 101, for example.

The semiconductor arrangement 100 may comprise a third lead frame 330 configured to electrically connect the fourth area 134 to a third external terminal, e.g. Phase as shown in Figure 3. The third lead frame 330 may be welded on the fourth area 134 of the substrate 101, for example.

The semiconductor arrangement 100 may comprise a fourth lead frame 310a as shown in Figure 3 configured to electrically connect the first area 131.

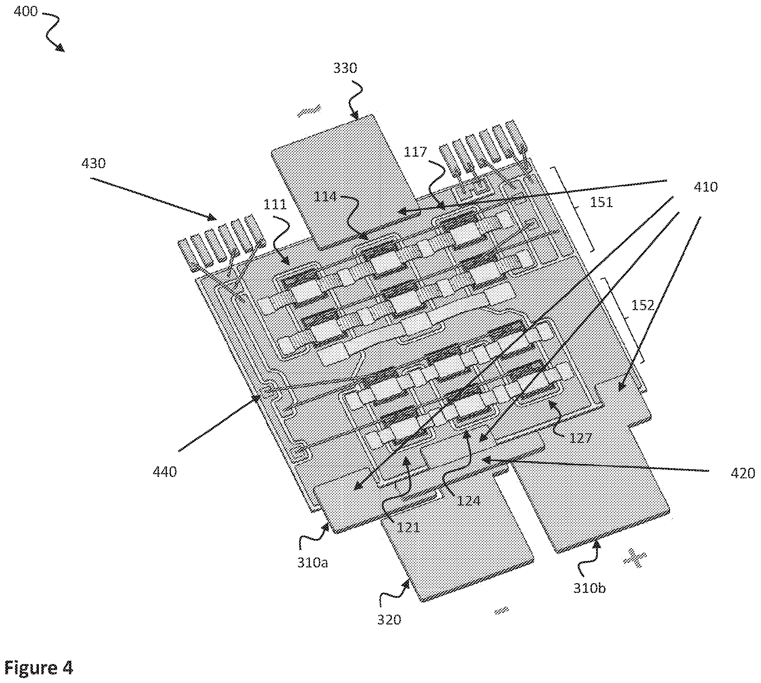

The semiconductor arrangement 100 may comprise an electrically conductive bridge 420 as shown in Figure 4 configured to electrically connect the fourth lead frame 310a with the first lead frame 310b by bridging the second lead frame 320.

The semiconductor arrangement 100 may comprise a mold compound (not shown in Figure 1) embedding the first group of semiconductor elements 111, 114, 117, the second group of semiconductor elements 121, 124, 127, the first electrical connection line 141, the second electrical connection line 143 and the third electrical connection line 142.

The semiconductor elements of the first group of semiconductor elements 111, 114, 117 and the semiconductor elements of the second group of semiconductor elements 121, 124, 127 may be Silicon Carbide semiconductors, for example.

The semiconductor arrangement 100 may form a single side cooled molded power module, e.g. for automotive applications.

The concept of this implementation is using a clip (as shown by the third electrical connection line 142) to connect collector of third/middle row of chips, (semiconductor elements) 114. The arrangement in three columns 121, 124, 128 on the low side 152 is accordingly in the columns without need for a clip. Aside a clip also ribbon bond(s) or standard wire bond(s) can be applied.

Fig. 2 shows a schematic diagram illustrating an exemplary H-bridge circuit 200 using semiconductor arrangements according to the disclosure.

The H-bridge circuit 200 can be implemented by two pair of switches 151, 152 as described above with respect to Figure 1. For example, the semiconductor arrangement 100 described above with respect to Figure 1 may form the two left side switches 151, 152 and another semiconductor arrangement 100 as described above with respect to Figure 1 may form the two right side switches 151b, 152b.

A load 210, for example an motor may be connected between the left side pair of switches 151, 152 and the right side pair of switches 151b, 152b. Based on switching the switches 151, 152, 151b, 152b, an alternating current path 211 is established to deliver an AC current to the load 210.

Fig. 3 shows a circuit diagram illustrating an exemplary semiconductor arrangement 300 according to the disclosure.

The semiconductor arrangement 300 corresponds to the semiconductor arrangement 100 described above with respect to Figure 1, but is additionally provided with external leads 310a, 310b, 320, 330 to provide external connections for the conducting areas 131, 133, 134, 135.

The semiconductor arrangement 300 comprises a first lead frame 310b configured to electrically connect the third area 133 to a first external terminal, e.g. terminal DC+. This terminal DC+ may correspond to the terminal P as depicted in Figure 2. The first lead frame 310b may be welded on the third area 133 of the substrate 101, for example.

The semiconductor arrangement 300 comprises a second lead frame 320 configured to electrically connect the fifth area 135 to a second external terminal, e.g. terminal DC-. This terminal DC- may correspond to the terminal N as depicted in Figure 2. The second lead 320 frame may be welded on the fifth area 135 of the substrate 101, for example.

The semiconductor arrangement 300 comprises a third lead frame 330 configured to electrically connect the fourth area 134 to a third external terminal, e.g. Phase. This Phase may correspond to the AC terminal for connecting the load 210 as shown in Figure 2. The third lead frame 330 may be welded on the fourth area 134 of the substrate 101, for example.

The semiconductor arrangement 300 comprises a fourth lead frame 310a configured to electrically connect the first area 131 to a fourth external terminal, e.g. terminal DC+. This fourth external terminal may be at the same electrical potential as the first external terminal, i.e. DC+. This terminal DC+ may correspond to the terminal P as depicted in Figure 2. Both terminals of DC+ may be arranged at different corners of the semiconductor arrangement 300.

The semiconductor arrangement 300 may comprise an electrically conductive bridge 420 as shown in Figure 4 configured to electrically connect the fourth lead frame 310a with the first lead frame 310b which are at the same electrical potential, i.e. DC+, by bridging the second lead frame 320 which may be at the inverse electrical potential, i.e. DC-.

As described above with respect to Figure 1, the semiconductor arrangement 300 may comprise a mold compound (not shown in Figure 3) embedding the first group of semiconductor elements 111, 114, 117, the second group of semiconductor elements 121, 124, 127, the first electrical connection line 141, the second electrical connection line 143 and the third electrical connection line 142.

The semiconductor elements of the first group of semiconductor elements 111, 114, 117 and the semiconductor elements of the second group of semiconductor elements 121, 124, 127 may be Silicon Carbide semiconductors, for example. Alternatively all semiconductor elements may be Silicon semiconductors.

The semiconductor arrangement 300 may form a single side cooled molded power module, e.g. for automotive, industrial or consumer electronic applications.

Due to this specific configuration of the semiconductor arrangement 300, where the first electrical connection line 141, the second electrical connection line 143, the third electrical connection line 142 and the fourth area 134 of the substrate 101 are dimensioned according to a symmetry criterion, this configuration enable a simultaneous current flow 301, 302 through the load paths of the semiconductor elements of the first group 111, 114, 117 as well as a simultaneous current flow 301, 302 through the load paths of the semiconductor elements of the second group 121, 124, 127.

The current flows 301, 302 are illustrated in Figure 3. It can be seen that the current paths through the semiconductor elements are symmetrically formed for both current paths, i.e. the left side current path 302 and the right side current path 301.

The left side current path 302 is established from left side DC+ via the first electrically conductive area 131, the first group of semiconductor elements 111, 114, 117, the first electrical connection line 141, the fourth electrically conductive area 134, the second group of semiconductor elements 121, 124, 127, the second electrical connection line 143, the fifth electrically conductive area 135 to terminal DC-.

The right side current path 301 is similarly established from right side DC+ via the first electrically conductive area 131, the first group of semiconductor elements 111, 114, 117, the first electrical connection line 141, the fourth electrically conductive area 134, the second group of semiconductor elements 121, 124, 127, the second electrical connection line 143, the fifth electrically conductive area 135 to terminal DC-.

The first group of semiconductor elements 111, 114, 117 may form the high side switch which can be controlled by high side signals 342. The second group of semiconductor elements 121, 124, 127 may form the low side switch which can be controlled by low side signals 341.

Each semiconductor element of the first group of semiconductor elements 111, 114, 117 may comprise a control electrode which can be controlled by the high side signals 342. For example, the control electrodes of the semiconductor elements of the first group of semiconductor elements 111, 114, 117 may be connected by a connection line with the high side signals 342 for simultaneously controlling the respective semiconductor elements as shown in Figure 3.

Similarly, each semiconductor element of the second group of semiconductor elements 121, 124, 127 may comprise a control electrode which can be controlled by the low side signals 341. For example, the control electrodes of the semiconductor elements of the second group of semiconductor elements 121, 124, 127 may be connected by a connection line with the low side signals 341 for simultaneously controlling the respective semiconductor elements as shown in Figure 3.

Fig. 4 shows a circuit diagram illustrating an exemplary semiconductor arrangement 400 according to the disclosure.

The semiconductor arrangement 400 corresponds to the semiconductor arrangement 300 described above with respect to Figure 3, but is beside the welded lead frame 410 additionally provided with an internal DC+ bridge 420, a wire bond pull out design 430 and optional gate resistors with chip in series 440.

The semiconductor arrangement 400 comprises an electrically conductive bridge 420 configured to electrically connect the fourth lead frame 310a with the first lead frame 310b which are at the same electrical potential, i.e. DC+, by bridging the second lead frame 320 which may be at the inverse electrical potential, i.e. DC-.

As described above with respect to Figure 1, the semiconductor arrangement 400 may comprise a mold compound (not shown in Figure 4) embedding the first group of semiconductor elements 111, 114, 117, the second group of semiconductor elements 121, 124, 127, the first electrical connection line 141, the second electrical connection line 143 and the third electrical connection line 142.

The semiconductor elements of the first group of semiconductor elements 111, 114, 117 and the semiconductor elements of the second group of semiconductor elements 121, 124, 127 may be Silicon Carbide semiconductors, for example. Alternatively, all semiconductor elements may be Silicon semiconductors.

The semiconductor arrangement 300 may form a single side cooled molded power module, e.g. for automotive, industrial or consumer electronic applications.

Due to this specific configuration of the semiconductor arrangement 400, where the first electrical connection line 141, the second electrical connection line 143, the third electrical connection line 142 and the fourth area 134 of the substrate 101 are dimensioned according to a symmetry criterion, this configuration enables a simultaneous current flow 301, 302 through the load paths of the semiconductor elements of the first group 111, 114, 117 as well as a simultaneous current flow 301, 302 through the load paths of the semiconductor elements of the second group 121, 124, 127, as described above with respect to Figure 3.

As described above with respect to Figure 3, the current paths through the semiconductor elements are symmetrically formed for both current paths, i.e. the left-side current path 302 and the right-side current path 301.

The semiconductor arrangement 400 can be characterized by DC+ / DC- power pin arrangement and internal DC+ bridge. The internal DC+ Bridge 420 reduces stray inductance and ringing by a symmetrical cancellation. The wire bond pull out design 430 provides the technical advantage of design flexibility. Leads for signal pins are not attached to the leadframe by welding, soldering or sintering and substrate is connected to signal pins by wire bonds. This design improves routing flexibility as certain regions on the substrate can be crossed in electrical save distance.

Thus, the novel design provides a high symmetrical substrate layout that may be applied for molded single side cooled module, for example, enabling reliable switching of SiC chips within module. It is to be understood that also Si chips or chips based on other semiconductor technologies may be utilized in this novel design.

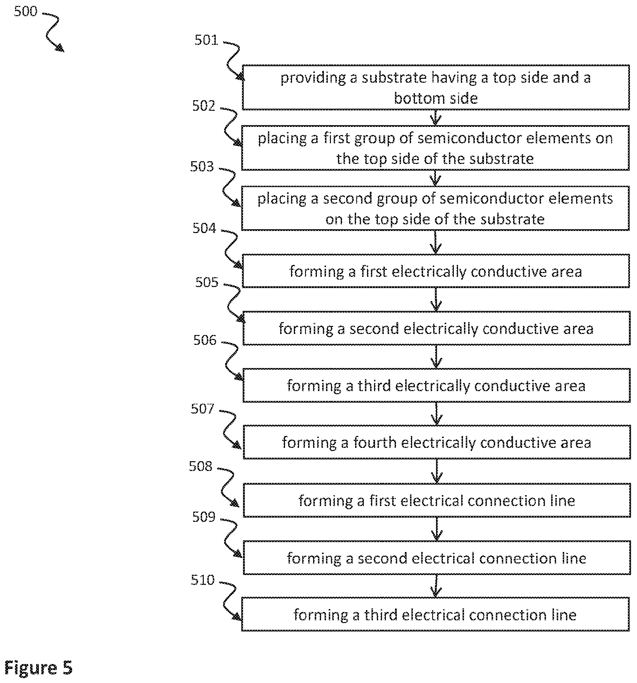

Fig. 5 shows a schematic diagram illustrating a method 500 for producing a semiconductor arrangement according to the disclosure.

The method 500 may be used for producing an semiconductor arrangement 100, 300, 400 as described above with respect to Figures 1 to 4.

The method 500 comprises: providing 501 a substrate 101 having a top side and a bottom side opposite to the top side.

The method 500 comprises: placing 502 a first load electrode of each semiconductor element of a first group of semiconductor elements 111, 114, 117 on the top side of the substrate, wherein the first group of semiconductor elements 111, 114, 117 form a first switch, each semiconductor element of the first group comprising a load path formed between a first load electrode arranged on a first main surface of the semiconductor element and a second load electrode arranged on a second main surface opposite to the first main surface of the semiconductor element.

The method 500 comprises: placing 503 a first load electrode of each semiconductor element of a second group of semiconductor elements 121, 124, 127 on the top side of the substrate, wherein the second group of semiconductor elements 121, 124, 127 forms a second switch, each semiconductor element of the second group comprising a load path formed between a first load electrode arranged on a first main surface of the semiconductor element and a second load electrode arranged on a second main surface opposite to the first main surface of the semiconductor element.

The method 500 comprises: forming 504 a first electrically conductive area 131 on the top side of the substrate, the first electrically conductive area 131 accommodating at least a first semiconductor element 112 of the first group of semiconductor elements 111, 114, 117.

The method 500 comprises: forming 505 a second electrically conductive area 132 on the top side of the substrate, the second area 132 insulated from the first area 131, the second area accommodating at least a second semiconductor element 115 of the first group of semiconductor elements 111, 114, 117;

The method 500 comprises: forming 506 a third electrically conductive area 133 on the top side of the substrate, the third area 133 insulated from the first area and the second area, the third area accommodating at least a third semiconductor element 118 of the first group of semiconductor elements 111, 114, 117.

The method 500 comprises: forming 507 a fourth electrically conductive area 134 insulated from the first area, the second area and the third area, the fourth area accommodating at least a first semiconductor element 122, a second semiconductor element 125 and a third semiconductor element 128 of the second group of semiconductor elements 121, 124, 127.

The method 500 comprises: forming 508 a first electrical connection line 141 electrically connecting the second load electrodes of the semiconductor elements of the first group 111, 114, 117 with each other and with the fourth area 134 of the substrate.

The method 500 comprises: forming 509 a second electrical connection line 143 electrically connecting the second load electrodes of the semiconductor elements of the second group 121, 124, 127 with each other.

The method 500 comprises: forming 510 a third electrical connection line 142 electrically connecting the first area 131, the second area 132 and the third area 133 of the substrate, wherein the first electrical connection line 141, the second electrical connection line 143, the third electrical connection line 142 and the fourth area 134 of the substrate 101 are dimensioned according to a symmetry criterion to enable a simultaneous current flow through the load paths of the semiconductor elements of the first group 111, 114, 117 as well as a simultaneous current flow through the load paths of the semiconductor elements of the second group 121, 124, 127.

While a particular feature or aspect of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Also, the terms "exemplary", "for example" and "e.g." are merely meant as an example, rather than the best or optimal. The terms "coupled" and "connected", along with derivatives may have been used. It should be understood that these terms may have been used to indicate that two elements cooperate or interact with each other regardless whether they are in direct physical or electrical contact, or they are not in direct contact with each other.

## Claims

1. A semiconductor arrangement (100), comprising:
a substrate (101) having a top side and a bottom side opposite to the top side;
a first group of semiconductor elements (111, 114, 117) forming a first switch, each semiconductor element of the first group comprising a load path formed between a first load electrode arranged on a first main surface of the respective semiconductor element and a second load electrode arranged on a second main surface opposite to the first main surface of the respective semiconductor element, wherein the first load electrode of each semiconductor element of the first group is placed on the top side of the substrate;
a second group of semiconductor elements (121, 124, 127) forming a second switch, each semiconductor element of the second group comprising a load path formed between a first load electrode arranged on a first main surface of the respective semiconductor element and a second load electrode arranged on a second main surface opposite to the first main surface of the respective semiconductor element, wherein the first load electrode of each semiconductor element of the second group is placed on the top side of the substrate;
wherein the substrate (101) comprises:
a first electrically conductive area (131) on the top side of the substrate, accommodating at least a first semiconductor element (112) of the first group of semiconductor elements (111, 114, 117);
a second electrically conductive area (132) on the top side of the substrate, separated from the first electrically conductive area, the second electrically conductive area accommodating at least a second semiconductor element (115) of the first group of semiconductor elements (111, 114, 117);
a third electrically conductive area (133) on the top side of the substrate, separated from the first electrically conductive area and the second electrically conductive area, the third electrically conductive area accommodating at least a third semiconductor element (118) of the first group of semiconductor elements (111, 114, 117);
a fourth electrically conductive area (134) insulated from the first electrically conductive area, the second electrically conductive area and the third electrically conductive area, the fourth electrically conductive area accommodating at least a first semiconductor element (122), a second semiconductor element (125) and a third semiconductor element (128) of the second group of semiconductor elements (121, 124, 127);
the semiconductor arrangement (100) further comprising:
a first electrical connection line (141) configured to electrically connect the second load electrodes of the semiconductor elements of the first group (111, 114, 117) with each other and with the fourth electrically conductive area (134) of the substrate;
a second electrical connection line (143) configured to electrically connect the second load electrodes of the semiconductor elements of the second group (121, 124, 127) with each other; and
a third electrical connection line (142) configured to electrically connect the first electrically conductive area (131), the second electrically conductive area (132) and the third electrically conductive area (133) of the substrate;
wherein the first electrical connection line (141), the second electrical connection line (143), the third electrical connection line (142) and the fourth electrically conductive area (134) of the substrate (101) are dimensioned according to a symmetry criterion to enable a simultaneous current flow through the load paths of the semiconductor elements of the first group (111, 114, 117) as well as a simultaneous current flow through the load paths of the semiconductor elements of the second group (121, 124, 127).

2. The semiconductor arrangement (100) of claim 1,
wherein the fourth electrically conductive area (134) of the substrate is dimensioned to separate the first electrically conductive area (131), the second electrically conductive area (132) and the third electrically conductive area (133) of the substrate from each other.

3. The semiconductor arrangement (100) of claim 1 or 2,
wherein the fourth electrically conductive area (134) of the substrate comprises a comb-shaped structure, wherein first teeth of the comb-shaped structure are dimensioned to separate the first electrically conductive area (131), the second area (132) and the third electrically conductive area (133) of the substrate from each other.

4. The semiconductor arrangement (100) of claim 3,
wherein second teeth of the comb-shaped structure are dimensioned to accommodate the first semiconductor element (122), the second semiconductor element (125) and the third semiconductor element (128) of the second group of semiconductor elements (121, 124, 127).

5. The semiconductor arrangement (100) of claim 4,
wherein the second teeth of the comb-shaped structure are formed opposite to the first teeth of the comb-shaped structure.

6. The semiconductor arrangement (100) of claim 4 or 5,
wherein the second teeth of the comb-shaped structure are sequentially and equidistantly arranged on the top side of the substrate.

7. The semiconductor arrangement (100) of any of the preceding claims,
wherein the first electrically conductive area (131), the second electrically conductive area (132) and the third electrically conductive area (133) are sequentially arranged on the top side of the substrate.

8. The semiconductor arrangement (100) of claim 7,
wherein a distance between the first electrically conductive area (131) to the second electrically conductive area (132) on the top side of the substrate corresponds to a distance between the second electrically conductive area (132) and the third electrically conductive area (133) on the top side of the substrate.

9. The semiconductor arrangement (100) of any of the preceding claims,
wherein the first electrical connection line (141) comprises a first part (141a) configured to electrically connect the second load electrodes of the first semiconductor element (112), the second semiconductor element (115) and the third semiconductor element (118) of the first group of semiconductor elements (111, 114, 117) with each other.

10. The semiconductor arrangement (100) of claim 9,
wherein the first part of the first electrical connection line (141) is dimensioned to form a straight connection line with respect to the top side of the substrate.

11. The semiconductor arrangement (100) of claim 9,
wherein the first electrical connection line (141) comprises a second part (141b) configured to electrically connect the second load electrodes of another semiconductor element (112b) of the first group arranged on the first electrically conductive area (131), another semiconductor element ((115b) of the second group arranged on the second electrically conductive area (132) and another semiconductor element (118b) of the third group arranged on the third electrically conductive area (131).

12. The semiconductor arrangement (100) of claim 11,
wherein the second part of the first electrical connection line (141) is dimensioned to form a straight connection line with respect to the top side of the substrate.

13. The semiconductor arrangement (100) of any of the preceding claims,
wherein the third electrical connection line (142) is dimensioned to form a straight connection line with respect to the top side of the substrate.

14. The semiconductor arrangement (100) of any of the preceding claims, comprising:
a fifth electrically conductive area (135) insulated from the first electrically conductive area, the second electrically conductive area, the third area and the fourth electrically conductive area,
wherein the second electrical connection line (143) is configured to electrically connect the second load electrodes of the semiconductor elements of the second group (121, 124, 127) with the fifth electrically conductive area (135).

15. The semiconductor arrangement (100) of claim 14, comprising:
a first lead frame configured to electrically connect the third electrically conductive area (133) to a first external terminal, wherein the first lead frame is welded on the third electrically conductive area (133) of the substrate;
a second lead frame configured to electrically connect the fifth electrically conductive area (135) to a second external terminal, wherein the second lead frame is welded on the fifth electrically conductive area (135) of the substrate; and
a third lead frame configured to electrically connect the fourth electrically conductive area (134) to a third external terminal, wherein the third lead frame is welded on the fourth electrically conductive area (134) of the substrate.

16. The semiconductor arrangement (100) of claim 15, comprising:
a fourth lead frame configured to electrically connect the first electrically conductive area (131); and
an electrically conductive bridge configured to electrically connect the fourth lead frame with the first lead frame by bridging the second lead frame.

17. The semiconductor arrangement (100) of any of the preceding claims, comprising:
a mold compound embedding the first group of semiconductor elements (111, 114, 117), the second group of semiconductor elements (121, 124, 127), the first electrical connection line (141), the second electrical connection line (143) and the third electrical connection line (142).

18. The semiconductor arrangement (100) of any of the preceding claims,
wherein the semiconductor elements of the first group of semiconductor elements (111, 114, 117) and the semiconductor element of the second group of semiconductor elements (121, 124, 127) are Silicon Carbide semiconductors.

19. The semiconductor arrangement (100) of any of the preceding claims,
forming a single side cooled molded power module for automotive applications.

## Patentansprüche

1. Halbleiteranordnung (100), die Folgendes umfasst:
ein Substrat (101) mit einer Oberseite und einer Unterseite gegenüber der Oberseite;
eine erste Gruppe von Halbleiterelementen (111, 114, 117), die einen ersten Schalter bilden, wobei jedes Halbleiterelement der ersten Gruppe einen Lastpfad umfasst, der zwischen einer ersten Lastelektrode, die auf einer ersten Hauptoberfläche des jeweiligen Halbleiterelements angeordnet ist, und einer zweiten Lastelektrode, die auf einer zweiten Hauptoberfläche gegenüber der ersten Hauptoberfläche des jeweiligen Halbleiterelements angeordnet ist, gebildet ist, wobei die erste Lastelektrode jedes Halbleiterelements der ersten Gruppe auf der Oberseite des Substrats platziert ist;
eine zweite Gruppe von Halbleiterelementen (121, 124, 127), die einen zweiten Schalter bilden, wobei jedes Halbleiterelement der zweiten Gruppe einen Lastpfad umfasst, der zwischen einer ersten Lastelektrode, die auf einer ersten Hauptoberfläche des jeweiligen Halbleiterelements angeordnet ist, und einer zweiten Lastelektrode, die auf einer zweiten Hauptoberfläche gegenüber der ersten Hauptoberfläche des jeweiligen Halbleiterelements angeordnet ist, gebildet ist, wobei die erste Lastelektrode jedes Halbleiterelements der zweiten Gruppe auf der Oberseite des Substrats platziert ist;
wobei das Substrat (101) Folgendes umfasst:
einen ersten elektrisch leitfähigen Bereich (131) auf der Oberseite des Substrats, der mindestens ein erstes Halbleiterelement (112) der ersten Gruppe von Halbleiterelementen (111, 114, 117) aufnimmt;
einen zweiten elektrisch leitfähigen Bereich (132) auf der Oberseite des Substrats, getrennt von dem ersten elektrisch leitfähigen Bereich, wobei der zweite elektrisch leitfähige Bereich mindestens ein zweites Halbleiterelement (115) der ersten Gruppe von Halbleiterelementen (111, 114, 117) aufnimmt;
einen dritten elektrisch leitfähigen Bereich (133) auf der Oberseite des Substrats, getrennt von dem ersten elektrisch leitfähigen Bereich und dem zweiten elektrisch leitfähigen Bereich, wobei der dritte elektrisch leitfähige Bereich mindestens ein drittes Halbleiterelement (118) der ersten Gruppe von Halbleiterelementen (111, 114, 117) aufnimmt;
einen vierten elektrisch leitfähigen Bereich (134), der von dem ersten elektrisch leitfähigen Bereich, dem zweiten elektrisch leitfähigen Bereich und dem dritten elektrisch leitfähigen Bereich isoliert ist, wobei der vierte elektrisch leitfähige Bereich mindestens ein erstes Halbleiterelement (122), ein zweites Halbleiterelement (125) und ein drittes Halbleiterelement (128) der zweiten Gruppe von Halbleiterelementen (121, 124, 127) aufnimmt;
wobei die Halbleiteranordnung (100) ferner Folgendes umfasst:
eine erste elektrische Verbindungsleitung (141), die dazu ausgebildet ist, die zweiten Lastelektroden der Halbleiterelemente der ersten Gruppe (111, 114, 117) elektrisch miteinander und mit dem vierten elektrisch leitfähigen Bereich (134) des Substrats zu verbinden;
eine zweite elektrische Verbindungsleitung (143), die dazu ausgebildet ist, die zweiten Lastelektroden der Halbleiterelemente der zweiten Gruppe (121, 124, 127) elektrisch miteinander zu verbinden; und
eine dritte elektrische Verbindungsleitung (142), die dazu ausgebildet ist, den ersten elektrisch leitfähigen Bereich (131), den zweiten elektrisch leitfähigen Bereich (132) und den dritten elektrisch leitfähigen Bereich (133) des Substrats elektrisch zu verbinden;
wobei die erste elektrische Verbindungsleitung (141), die zweite elektrische Verbindungsleitung (143), die dritte elektrische Verbindungsleitung (142) und der vierte elektrisch leitfähige Bereich (134) des Substrats (101) gemäß einem Symmetriekriterium dimensioniert sind, um einen gleichzeitigen Stromfluss durch die Lastpfade der Halbleiterelemente der ersten Gruppe (111, 114, 117) sowie einen gleichzeitigen Stromfluss durch die Lastpfade der Halbleiterelemente der zweiten Gruppe (121, 124, 127) zu ermöglichen.

2. Halbleiteranordnung (100) nach Anspruch 1,
wobei der vierte elektrisch leitfähige Bereich (134) des Substrats so dimensioniert ist, dass er den ersten elektrisch leitfähigen Bereich (131), den zweiten elektrisch leitfähigen Bereich (132) und den dritten elektrisch leitfähigen Bereich (133) des Substrats voneinander trennt.

3. Halbleiteranordnung (100) nach Anspruch 1 oder 2,
wobei der vierte elektrisch leitfähige Bereich (134) des Substrats eine kammförmige Struktur umfasst, wobei erste Zähne der kammförmigen Struktur so dimensioniert sind, dass sie den ersten elektrisch leitfähigen Bereich (131), den zweiten Bereich (132) und den dritten elektrisch leitfähigen Bereich (133) des Substrats voneinander trennen.

4. Halbleiteranordnung (100) nach Anspruch 3,
wobei zweite Zähne der kammförmigen Struktur so dimensioniert sind, dass sie das erste Halbleiterelement (122), das zweite Halbleiterelement (125) und das dritte Halbleiterelement (128) der zweiten Gruppe von Halbleiterelementen (121, 124, 127) aufnehmen.

5. Halbleiteranordnung (100) nach Anspruch 4,
wobei die zweiten Zähne der kammförmigen Struktur entgegengesetzt zu den ersten Zähnen der kammförmigen Struktur gebildet sind.

6. Halbleiteranordnung (100) nach Anspruch 4 oder 5,
wobei die zweiten Zähne der kammförmigen Struktur sequentiell und äquidistant auf der Oberseite des Substrats angeordnet sind.

7. Halbleiteranordnung (100) nach einem der vorhergehenden Ansprüche,
wobei der erste elektrisch leitfähige Bereich (131), der zweite elektrisch leitfähige Bereich (132) und der dritte elektrisch leitfähige Bereich (133) sequentiell auf der Oberseite des Substrats angeordnet sind.

8. Halbleiteranordnung (100) nach Anspruch 7,
wobei ein Abstand zwischen dem ersten elektrisch leitfähigen Bereich (131) zu dem zweiten elektrisch leitfähigen Bereich (132) auf der Oberseite des Substrats einem Abstand zwischen dem zweiten elektrisch leitfähigen Bereich (132) und dem dritten elektrisch leitfähigen Bereich (133) auf der Oberseite des Substrats entspricht.

9. Halbleiteranordnung (100) nach einem der vorhergehenden Ansprüche,
wobei die erste elektrische Verbindungsleitung (141) einen ersten Teil (141a) umfasst, der dazu ausgebildet ist, die zweiten Lastelektroden des ersten Halbleiterelements (112), des zweiten Halbleiterelements (115) und des dritten Halbleiterelements (118) der ersten Gruppe von Halbleiterelementen (111, 114, 117) elektrisch miteinander zu verbinden.

10. Halbleiteranordnung (100) nach Anspruch 9,
wobei der erste Teil der ersten elektrischen Verbindungsleitung (141) so dimensioniert ist, dass er eine gerade Verbindungsleitung mit Bezug auf die Oberseite des Substrats bildet.

11. Halbleiteranordnung (100) nach Anspruch 9,
wobei die erste elektrische Verbindungsleitung (141) einen zweiten Teil (141b) umfasst, der dazu ausgebildet ist, die zweiten Lastelektroden eines anderen Halbleiterelements (112b) der ersten Gruppe, das auf dem ersten elektrisch leitfähigen Bereich (131) angeordnet ist, eines anderen Halbleiterelements (115b) der zweiten Gruppe, das auf dem zweiten elektrisch leitfähigen Bereich (132) angeordnet ist, und eines anderen Halbleiterelements (118b) der dritten Gruppe, das auf dem dritten elektrisch leitfähigen Bereich (131) angeordnet ist, elektrisch zu verbinden.

12. Halbleiteranordnung (100) nach Anspruch 11,
wobei der zweite Teil der ersten elektrischen Verbindungsleitung (141) so dimensioniert ist, dass er eine gerade Verbindungsleitung mit Bezug auf die Oberseite des Substrats bildet.

13. Halbleiteranordnung (100) nach einem der vorhergehenden Ansprüche,
wobei die dritte elektrische Verbindungsleitung (142) so dimensioniert ist, dass sie eine gerade Verbindungsleitung mit Bezug auf die Oberseite des Substrats bildet.

14. Halbleiteranordnung (100) nach einem der vorhergehenden Ansprüche, die Folgendes umfasst:
einen fünften elektrisch leitfähigen Bereich (135), der von dem ersten elektrisch leitfähigen Bereich, dem zweiten elektrisch leitfähigen Bereich, dem dritten Bereich und dem vierten elektrisch leitfähigen Bereich isoliert ist,
wobei die zweite elektrische Verbindungsleitung (143) dazu ausgebildet ist, die zweiten Lastelektroden der Halbleiterelemente der zweiten Gruppe (121, 124, 127) elektrisch mit dem fünften elektrisch leitfähigen Bereich (135) zu verbinden.

15. Halbleiteranordnung (100) nach Anspruch 14, die Folgendes umfasst:
einen ersten Leiterrahmen, der dazu ausgebildet ist, den dritten elektrisch leitfähigen Bereich (133) elektrisch mit einem ersten externen Anschluss zu verbinden, wobei der erste Leiterrahmen auf den dritten elektrisch leitfähigen Bereich (133) des Substrats geschweißt ist;
einen zweiten Leiterrahmen, der dazu ausgebildet ist, den fünften elektrisch leitfähigen Bereich (135) elektrisch mit einem zweiten externen Anschluss zu verbinden, wobei der zweite Leiterrahmen auf den fünften elektrisch leitfähigen Bereich (135) des Substrats geschweißt ist; und
einen dritten Leiterrahmen, der dazu ausgebildet ist, den vierten elektrisch leitfähigen Bereich (134) elektrisch mit einem dritten externen Anschluss zu verbinden, wobei der dritte Leiterrahmen auf den vierten elektrisch leitfähigen Bereich (134) des Substrats geschweißt ist.

16. Halbleiteranordnung (100) nach Anspruch 15, die Folgendes umfasst:
einen vierten Leiterrahmen, der dazu ausgebildet ist, den ersten elektrisch leitfähigen Bereich (131) elektrisch zu verbinden; und
eine elektrisch leitfähige Brücke, die dazu ausgebildet ist, den vierten Leiterrahmen durch Überbrücken des zweiten Leiterrahmens elektrisch mit dem ersten Leiterrahmen zu verbinden.

17. Halbleiteranordnung (100) nach einem der vorhergehenden Ansprüche, die Folgendes umfasst:
eine Vergussmasse, die die erste Gruppe von Halbleiterelementen (111, 114, 117), die zweite Gruppe von Halbleiterelementen (121, 124, 127), die erste elektrische Verbindungsleitung (141), die zweite elektrische Verbindungsleitung (143) und die dritte elektrische Verbindungsleitung (142) einbettet.

18. Halbleiteranordnung (100) nach einem der vorhergehenden Ansprüche,
wobei die Halbleiterelemente der ersten Gruppe von Halbleiterelementen (111, 114, 117) und das Halbleiterelement der zweiten Gruppe von Halbleiterelementen (121, 124, 127) Siliziumkarbid-Halbleiter sind.

19. Halbleiteranordnung (100) nach einem der vorhergehenden Ansprüche,
die ein einseitig gekühltes gegossenes Leistungsmodul für Automobilanwendungen bildet.

## Revendications

1. Agencement de semi-conducteurs (100), comprenant :
un substrat (101) ayant un côté supérieur et un côté inférieur opposé au côté supérieur ;
un premier groupe (111, 114, 117) d'éléments semi-conducteurs formant un premier commutateur, chaque élément semi-conducteur du premier groupe comprenant un chemin de charge formé entre une première électrode de charge agencée sur une première surface principale de l'élément semi-conducteur respectif et une deuxième électrode de charge agencée sur une deuxième surface principale opposée à la première surface principale de l'élément semi-conducteur respectif, la première électrode de charge de chaque élément semi-conducteur du premier groupe étant disposée sur le côté supérieur du substrat ;
un deuxième groupe (121, 124, 127) d'éléments semi-conducteurs formant un deuxième commutateur, chaque élément semi-conducteur du deuxième groupe comprenant un chemin de charge formé entre une première électrode de charge agencée sur une première surface principale de l'élément semi-conducteur respectif et une deuxième électrode de charge agencée sur une deuxième surface principale opposée à la première surface principale de l'élément semi-conducteur respectif, la première électrode de charge de chaque élément semi-conducteur du deuxième groupe étant disposée sur le côté supérieur du substrat ;
le substrat (101) comprenant :
une première zone électriquement conductrice (131) sur le côté supérieur du substrat, accueillant au moins un premier élément semi-conducteur (112) du premier groupe (111, 114, 117) d'éléments semi-conducteurs ;
une deuxième zone électriquement conductrice (132) sur le côté supérieur du substrat, séparée de la première zone électriquement conductrice, la deuxième zone électriquement conductrice accueillant au moins un deuxième élément semi-conducteur (115) du premier groupe (111, 114, 117) d'éléments semi-conducteurs ;
une troisième zone électriquement conductrice (133) sur le côté supérieur du substrat, séparée de la première zone électriquement conductrice et de la deuxième zone électriquement conductrice, la troisième zone électriquement conductrice accueillant au moins un troisième élément semi-conducteur (118) du premier groupe (111, 114, 117) d'éléments semi-conducteurs ;
une quatrième zone électriquement conductrice (134) isolée de la première zone électriquement conductrice, de la deuxième zone électriquement conductrice et de la troisième zone électriquement conductrice, la quatrième zone électriquement conductrice accueillant au moins un premier élément semi-conducteur (122), un deuxième élément semi-conducteur (125) et un troisième élément semi-conducteur (128) du deuxième groupe (121, 124, 127) d'éléments semi-conducteurs ;
l'agencement de semi-conducteurs (100) comprenant en outre :
une première ligne de connexion électrique (141) configurée pour connecter électriquement les deuxièmes électrodes de charge des éléments semi-conducteurs du premier groupe (111, 114, 117) entre elles et avec la quatrième zone électriquement conductrice (134) du substrat ;
une deuxième ligne de connexion électrique (143) configurée pour connecter électriquement les deuxièmes électrodes de charge des éléments semi-conducteurs du deuxième groupe (121, 124, 127) entre elles ; et
une troisième ligne de connexion électrique (142) configurée pour connecter électriquement la première zone électriquement conductrice (131), la deuxième zone électriquement conductrice (132) et la troisième zone électriquement conductrice (133) du substrat ;
la première ligne de connexion électrique (141), la deuxième ligne de connexion électrique (143), la troisième ligne de connexion électrique (142) et la quatrième zone électriquement conductrice (134) du substrat (101) étant dimensionnées selon un critère de symétrie pour permettre une circulation de courant simultanée dans les chemins de charge des éléments semi-conducteurs du premier groupe (111, 114, 117) ainsi qu'une circulation de courant simultanée dans les chemins de charge des éléments semi-conducteurs du deuxième groupe (121, 124, 127).

2. Agencement de semi-conducteurs (100) selon la revendication 1,
la quatrième zone électriquement conductrice (134) du substrat étant dimensionnée pour séparer la première zone électriquement conductrice (131), la deuxième zone électriquement conductrice (132) et la troisième zone électriquement conductrice (133) du substrat les unes des autres.

3. Agencement de semi-conducteurs (100) selon la revendication 1 ou 2,
la quatrième zone électriquement conductrice (134) du substrat comprenant une structure en forme de peigne, des premières dents de la structure en forme de peigne étant dimensionnées pour séparer la première zone électriquement conductrice (131), la deuxième zone (132) et la troisième zone électriquement conductrice (133) du substrat les unes des autres.

4. Agencement de semi-conducteurs (100) selon la revendication 3,
des deuxièmes dents de la structure en forme de peigne étant dimensionnées pour recevoir le premier élément semi-conducteur (122), le deuxième élément semi-conducteur (125) et le troisième élément semi-conducteur (128) du deuxième groupe (121, 124, 127) d'éléments semi-conducteurs.

5. Agencement de semi-conducteurs (100) selon la revendication 4,
les deuxièmes dents de la structure en forme de peigne étant formées à l'opposé des premières dents de la structure en forme de peigne.

6. Agencement de semi-conducteurs (100) selon la revendication 4 ou 5,
les deuxièmes dents de la structure en forme de peigne étant disposées séquentiellement et de manière équidistante sur le côté supérieur du substrat.

7. Agencement de semi-conducteurs (100) selon l'une quelconque des revendications précédentes,
la première zone électriquement conductrice (131), la deuxième zone électriquement conductrice (132) et la troisième zone électriquement conductrice (133) étant disposées séquentiellement sur le côté supérieur du substrat.

8. Agencement de semi-conducteurs (100) selon la revendication 7,
une distance entre la première zone électriquement conductrice (131) et la deuxième zone électriquement conductrice (132) sur le côté supérieur du substrat correspondant à une distance entre la deuxième zone électriquement conductrice (132) et la troisième zone électriquement conductrice (133) sur le côté supérieur du substrat.

9. Agencement de semi-conducteurs (100) selon l'une quelconque des revendications précédentes,
la première ligne de connexion électrique (141) comprenant une première partie (141a) configurée pour connecter électriquement les deuxièmes électrodes de charge du premier élément semi-conducteur (112), le deuxième élément semi-conducteur (115) et le troisième élément semi-conducteur (118) du premier groupe (111, 114, 117) d'éléments semi-conducteurs entre elles.

10. Agencement de semi-conducteurs (100) selon la revendication 9,
la première partie de la première ligne de connexion électrique (141) étant dimensionnée pour former une ligne de connexion droite par rapport au côté supérieur du substrat.

11. Agencement de semi-conducteurs (100) selon la revendication 9,
la première ligne de connexion électrique (141) comprenant une deuxième partie (141b) configurée pour connecter électriquement les deuxièmes électrodes de charge d'un autre élément semi-conducteur (112b) du premier groupe agencé sur la première zone électriquement conductrice (131), d'un autre élément semi-conducteur ((115b) du deuxième groupe agencé sur la deuxième zone électriquement conductrice (132) et d'un autre élément semi-conducteur (118b) du troisième groupe agencé sur la troisième zone électriquement conductrice (131).

12. Agencement de semi-conducteurs (100) selon la revendication 11,
la deuxième partie de la première ligne de connexion électrique (141) étant dimensionnée pour former une ligne de connexion droite par rapport au côté supérieur du substrat.

13. Agencement de semi-conducteurs (100) selon l'une quelconque des revendications précédentes,
la troisième ligne de connexion électrique (142) étant dimensionnée pour former une ligne de connexion droite par rapport au côté supérieur du substrat.

14. Agencement de semi-conducteurs (100) selon l'une quelconque des revendications précédentes, comprenant :
une cinquième zone électriquement conductrice (135) isolée de la première zone électriquement conductrice, de la deuxième zone électriquement conductrice, de la troisième zone et de la quatrième zone électriquement conductrice,
la deuxième ligne de connexion électrique (143) étant configurée pour connecter électriquement les deuxièmes électrodes de charge des éléments semi-conducteurs du deuxième groupe (121, 124, 127) à la cinquième zone électriquement conductrice (135).

15. Agencement de semi-conducteurs (100) selon la revendication 14, comprenant :
une première grille de connexion configurée pour connecter électriquement la troisième zone électriquement conductrice (133) à une première borne externe, la première grille de connexion étant soudée sur la troisième zone électriquement conductrice (133) du substrat ;
une deuxième grille de connexion configurée pour connecter électriquement la cinquième zone électriquement conductrice (135) à une deuxième borne externe, la deuxième grille de connexion étant soudée sur la cinquième zone électriquement conductrice (135) du substrat ; et
une troisième grille de connexion configurée pour connecter électriquement la quatrième zone électriquement conductrice (134) à une troisième borne externe, la troisième grille de connexion étant soudée sur la quatrième zone électriquement conductrice (134) du substrat.

16. Agencement de semi-conducteurs (100) selon la revendication 15, comprenant :
une quatrième grille de connexion configurée pour connecter électriquement la première zone électriquement conductrice (131) ; et
un pont électriquement conducteur configuré pour connecter électriquement la quatrième grille de connexion à la première grille de connexion en formant un pont vers la deuxième grille de connexion.

17. Agencement de semi-conducteurs (100) selon l'une quelconque des revendications précédentes, comprenant :
un composé de moulage intégrant le premier groupe (111, 114, 117) d'éléments semi-conducteurs, le deuxième groupe (121, 124, 127) d'éléments semi-conducteurs, la première ligne de connexion électrique (141), la deuxième ligne de connexion électrique (143) et la troisième ligne de connexion électrique (142).

18. Agencement de semi-conducteurs (100) selon l'une quelconque des revendications précédentes,
les éléments semi-conducteurs du premier groupe (111, 114, 117) d'éléments semi-conducteurs et les éléments semi-conducteurs du deuxième groupe (121, 124, 127) d'éléments semi-conducteurs étant des semi-conducteurs en carbure de silicium.

19. Agencement de semi-conducteurs (100) selon l'une quelconque des revendications précédentes,
formant un module de puissance moulé refroidi d'un seul côté pour des applications automobiles.
